# EUROPEAN PATENT APPLICATION

(11) **EP 4 207 547 A1**
(43) Date of publication of application: **05.07.2023**
(21) Application number: 22820623.1
(22) Date of filing: 10.06.2022
(51) Int. Cl.: H02J 7/00, G01R 31/382, G01R 19/165, B60L 58/15, B60L 3/00

(54) **OVER-DISCHARGE PREVENTION DEVICE AND METHOD**

(30) Priority: 11.06.2021 KR 20210076258
(71) Applicant: LG Energy Solution, Ltd., Seoul 07335 (KR)
(72) Inventor: CHOI, Jang-Hyeok, Daejeon 34122 (KR); YU, Dong-Hyeon, Daejeon 34122 (KR)
(74) Representative: Hoffmann Eitle
(86) International application number: PCT/KR2022/008259
(87) International publication number: WO 2022/260496

(57) **Abstract**

An overdischarge preventing apparatus according to an embodiment of the present disclosure is an apparatus for preventing a battery pack provided in a vehicle from being overdischarged, and includes a measuring unit configured to measure a voltage of a main battery provided in the battery pack according to an operation mode; and a control unit configured to judge an operation state of a charging and discharging relay connected to the main battery, and control the operation mode of the measuring unit based on at least one of the judged operation state of the charging and discharging relay, whether the vehicle is stopped, and the voltage of the main battery measured by the measuring unit.

## Description

### TECHNICAL FIELD

The present application claims priority to Korean Patent Application No. 10-2021-0076258 filed on June 11, 2021 in the Republic of Korea, the disclosures of which are incorporated herein by reference.

The present disclosure relates to an overdischarge preventing apparatus and method, and more particularly, to an overdischarge preventing apparatus and method, which may prevent a main battery provided to a battery pack from being overcharged.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-discharging rate and high energy density.

Although many studies are being conducted on these batteries in terms of high capacity and high density, life and safety improvement are also important. To this end, it is required to prevent that the battery is overcharged or overdischarged.

Even if the battery does not supply power to a load such as a motor, power may be continuously supplied to a battery monitoring IC (BMIC) that measures state information of at least one of temperature, voltage and current of the battery. In this case, since the energy stored in the battery is consumed by the BMIC, there is a problem in that the battery may be overdischarged. Therefore, it is necessary to develop a technology for preventing the battery from being overdischarged by the BMIC.

### DISCLOSURE

### Technical Problem

The present disclosure is designed to solve the problems of the related art, and therefore the present disclosure is directed to providing an overdischarge preventing apparatus and method, which may prevent a battery from being overdischarged based on voltage information of a battery and information of a battery pack and a vehicle.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An overdischarge preventing apparatus according to one aspect of the present disclosure may comprise: a measuring unit configured to measure a voltage of a main battery provided in the battery pack according to an operation mode; and a control unit configured to judge an operation state of a charging and discharging relay connected to the main battery, and control the operation mode of the measuring unit based on at least one of the judged operation state of the charging and discharging relay, whether the vehicle is stopped, and the voltage of the main battery measured by the measuring unit.

The measuring unit may be configured to operate in any one operation mode among a wake-up mode in which the voltage of the main battery is measured in a first measurement cycle, an eco-mode in which the voltage of the main battery is measured in a second measurement cycle longer than the first measurement cycle, and a shutdown mode in which the voltage of the main battery is not measured.

The control unit may be configured to control the operation mode of the measuring unit based on at least one of whether the vehicle is stopped and the voltage of the main battery, when the operation mode of the measuring unit is the wake-up mode and the operation state of the charging and discharging relay is a turn-off state.

The control unit may be configured to judge whether the vehicle is stopped, and change the operation mode of the measuring unit to the eco-mode when it is judged that the vehicle is stopped.

The control unit may be configured to judge whether the vehicle is stopped, based on at least one of speed information of the vehicle and rotation information of a wheel, which are received from the outside.

The control unit may be configured to change the operation mode of the measuring unit to the eco-mode, when a present voltage of the main battery is equal to or lower than a preset threshold voltage.

The control unit may be configured to change the operation mode of the measuring unit to the eco-mode, when the voltage of the main battery decreases at a criterion ratio or more during a plurality of cycles.

The control unit may be configured to control the charging and discharging relay or the operation mode of the measuring unit according to whether a charging device is connected to the battery pack within a preset time, after the operation mode of the measuring unit is changed to the eco-mode.

The control unit may be configured to charge the main battery through the charging device by controlling the operation state of the charging and discharging relay to a turn-on state, when the charging device is connected to the battery pack within the preset time.

The control unit may be configured to change the operation mode of the measuring unit from the eco-mode to the wake-up mode, when the voltage of the main battery exceeds a preset criterion voltage.

The control unit may be configured to change the operation mode of the measuring unit to the shutdown mode, when the charging device is not connected to the battery pack within the preset time.

When the control unit receives a wake-up signal from a starting battery different from the main battery, the control unit may be configured to change an operation mode from a sleep mode to a wake-up mode and change the operation mode of the measuring unit from the shutdown mode to the wake-up mode.

When the operation mode of the measuring unit is the wake-up mode or the eco-mode, the measuring unit may be configured to receive an operating power from the main battery and measure the voltage of the main battery.

A battery pack according to another aspect of the present disclosure may comprise the overdischarge preventing apparatus according to an aspect of the present disclosure.

A vehicle according to another aspect of the present disclosure may comprise the overdischarge preventing apparatus according to an aspect of the present disclosure.

An overdischarge preventing method according to another aspect of the present disclosure may be a method for preventing a battery pack provided in a vehicle from being overdischarged, and may comprise a voltage measuring step of, by a measuring unit, measuring a voltage of a main battery provided in the battery pack; an operation state judging step of, by a control unit, judging an operation state of a charging and discharging relay connected to the main battery; and an operation mode controlling step of, by the control unit, controlling an operation mode of the measuring unit based on at least one of the operation state of the charging and discharging relay, whether the vehicle is stopped, and the voltage of the main battery.

### Advantageous Effects

According to one aspect of the present disclosure, since the operation mode of the measuring unit that receives power from the battery and measures the voltage of the battery is appropriately controlled, it is possible to prevent the battery from being overdischarged.

The effects of the present disclosure are not limited to the above, and other effects not mentioned herein will be clearly understood by those skilled in the art from the appended claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an overdischarge preventing apparatus according to an embodiment of the present disclosure.
FIG. 2 is a diagram schematically showing an exemplary configuration of a battery pack according to another embodiment of the present disclosure.
FIG. 3 is a diagram schematically showing another exemplary configuration of a vehicle according to another embodiment of the present disclosure.
FIG. 4 is a diagram schematically showing an overdischarge preventing method according to another embodiment of the present disclosure.
FIG. 5 is a diagram more specifically showing the overdischarge preventing method according to another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

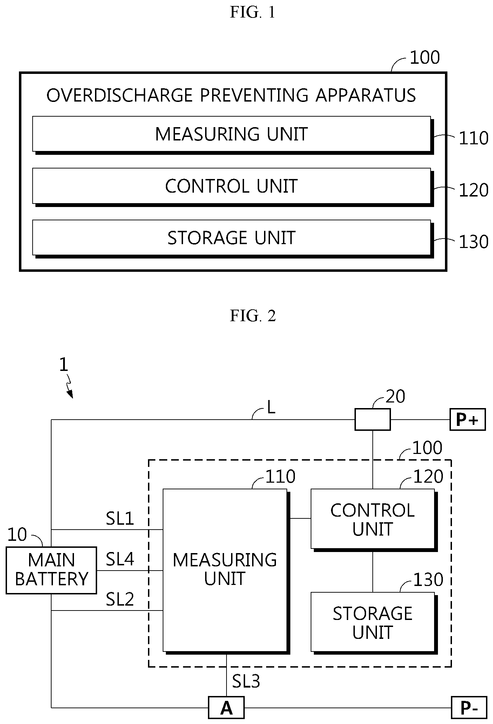

FIG. 1 is a diagram schematically showing an overdischarge preventing apparatus 100 according to an embodiment of the present disclosure. FIG. 2 is a diagram schematically showing an exemplary configuration of a battery pack 1 according to another embodiment of the present disclosure.

Referring to FIG. 1, the overdischarge preventing apparatus 100 according to an embodiment of the present disclosure is an apparatus for preventing the battery pack 1 provided in a vehicle from being overdischarged, and may include a measuring unit 110 and a control unit 120.

The measuring unit 110 may be configured to measure the voltage of a main battery 10 provided in the battery pack 1 according to the operation mode.

Here, the main battery 10 refers to one physically separable independent cell having a negative electrode terminal and a positive electrode terminal. For example, a lithium-ion battery or a lithium polymer cell may be regarded as the battery. In addition, the main battery 10 may refer to a battery module in which a plurality of cells are connected in series and/or in parallel. Hereinafter, for convenience of description, the main battery 10 will be described as meaning a battery module.

The measuring unit 110 may be connected to communicate with the control unit 120, and may transmit the measured voltage of the main battery 10 to the control unit 120.

For example, the measuring unit 110 may be a battery monitoring IC (BMIC) capable of measuring the voltage of the main battery 10. In addition, the measuring unit 110 may further measure the current and temperature of the main battery 10.

Specifically, the measuring unit 110 may be operated in any one operation mode among a wake-up mode, an eco-mode, and a shutdown mode. In addition, the operation mode of the measuring unit 110 may be controlled by the control unit 120.

For example, the wake-up mode is a mode in which the voltage of the main battery 10 is measured in a first measurement cycle, and the eco-mode is a mode in which the voltage of the main battery 10 is measured in a second measurement cycle longer than the first measurement cycle. In addition, the shutdown mode is a mode in which the voltage of the main battery 10 is not measured, and may be the same mode as a sleep mode generally expressed.

The control unit 120 may be configured to judge the operation state of the charging and discharging relay 20 connected to the main battery 10.

The charging and discharging relay 20 may be provided on the charging and discharging path L of the main battery 10 in the battery pack 1. Here, the charging and discharging path L is a path where the positive electrode terminal P+ of the battery pack 1, the main battery 10 and the negative electrode terminal P- of the battery pack 1 are connected, and may be a large current path through which the charging current and the discharging current of the main battery 10 flow.

For example, in the embodiment of FIG. 2, the charging and discharging relay 20 may be connected in series between the positive electrode terminal of the main battery 10 and the positive electrode terminal P+ of the battery pack 1. When the charging and discharging relay 20 is in the turn-off state, the main battery 10 and the positive electrode terminal P+ of the battery pack 1 may not be electrically connected, and when the charging and discharging relay 20 is in the turn-on state, the main battery 10 and the positive electrode terminal P+ of the battery pack 1 may be electrically connected.

Specifically, the control unit 120 may control the operation state of the charging and discharging relay 20. For example, the control unit 120 may control the operation state of the charging and discharging relay 20 as a turn-on state or a turn-off state.

Accordingly, the control unit 120 may judge the operation state of the present charging and discharging relay 20 based on the control information of the charging and discharging relay 20. For example, the control unit 120 may judge the present operation state of the charging and discharging relay 20 as a turn-on state or a turn-off state based on the control information for the charging and discharging relay 20.

The control unit 120 may be configured to control the operation mode of the measuring unit 110 based on at least one of the operation state of the charging and discharging relay 20 of the main battery 10 provided in the battery pack 1, whether the vehicle is stopped, and the voltage of the main battery 10 measured by the measuring unit 110.

Preferably, when the operation mode of the measuring unit 110 is a wake-up mode and the operation state of the charging and discharging relay 20 is a turn-off state, the control unit 120 may be configured to control the operation mode of the measuring unit 110 based on at least one of whether the vehicle is stopped and the voltage of the main battery 10.

Here, the voltage of the main battery 10 may have a corresponding relationship with the SOC (State of Charge) of the main battery 10. For example, the voltage of the main battery 10 may have a one-to-one corresponding relationship with the SOC. Therefore, for convenience of explanation, an embodiment in which the control unit 120 controls the operation mode of the measuring unit 110 in consideration of the voltage of the main battery 10 is described below, but it should be noted that the embodiment in which the control unit 120 may controls the operation mode of the measuring unit 110 in consideration of the SOC instead of the voltage of the main battery 10 can also be easily derived. For example, the control unit 120 may estimate the SOC of the main battery 10 based on the voltage of the main battery 10, and control the operation mode of the measuring unit 110 based on at least one of whether the vehicle is stopped and the estimated SOC.

Specifically, the control unit 120 may control the operation mode of the measuring unit 110 when the connection between the battery pack 1 and the motor (not shown) of the vehicle is released because the operation state of the charging and discharging relay 20 is a turn-off state.

For example, when the operation state of the charging and discharging relay 20 is a turn-on state, the battery pack 1 and the motor of the vehicle may be electrically connected so that the vehicle is in a running state. When the vehicle is in a running state, the voltage behavior of the main battery 10 must be measured in real time in a short cycle, so the control unit 120 is able to control the operation mode of the measuring unit 110 based on whether the vehicle is stopped and/or the voltage of the main battery 10, only when the charging and discharging relay 20 is in the turn-off state.

In addition, in order to judge whether the vehicle is stopped, the control unit 120 may receive at least one information capable of judging whether the vehicle is stopped from the outside.

Specifically, the control unit 120 may receive at least one information capable of judging whether the vehicle is stopped from the vehicle control device 3 included in the vehicle.

For example, the control unit 120 may receive speed information of the vehicle and/or rotation information of the wheel from the vehicle control device 3 included in the vehicle, and judge whether the vehicle is stopped based on the received information. Here, the vehicle control device 3 may be an Electronic Control Unit (ECU) provided in the vehicle. On the other hand, it should be noted that the control unit 120 may receive more various information from the vehicle control device 3 in order to judge whether the vehicle is stopped.

Also, the control unit 120 may receive the voltage information of the main battery 10 from the measuring unit 110.

That is, the overdischarge preventing apparatus 100 may prevent the main battery 10 from being overcharged by the measuring unit 110 by appropriately controlling the operation mode of the measuring unit 110 based on whether the vehicle is stopped and/or the voltage of the main battery 10, when the operation state of the charging and discharging relay 20 is a turn-off state.

Therefore, since the operation mode of the measuring unit 110 for measuring the state (voltage, current and/or temperature) of the main battery 10 is properly controlled by the overdischarge preventing apparatus 100, it is possible to effectively prevent the main battery 10 from being overdischarged by the measuring unit 110.

Meanwhile, the control unit 120 included in the overdischarge preventing apparatus 100 may optionally include an application-specific integrated circuit (ASIC), another chipset, a logic circuit, a register, a communication modem, and a data processing device, and the like, known in the art to execute various control logics disclosed below. In addition, when the control logic is implemented in software, the control unit 120 may be implemented as a set of program modules. In this case, the program module may be stored in a memory and executed by the control unit 120. The memory may be inside or outside the control unit 120, and may be connected to the control unit 120 by various well-known means.

In addition, the overdischarge preventing apparatus 100 may further include a storage unit 130. The storage unit 130 may store programs, data and the like required for each component of the overdischarge preventing apparatus 100 to perform operations and functions, or may store data or the like generated in the process of performing operations and functions. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Hereinafter, an embodiment in which the control unit 120 changes the operation mode of the measuring unit 110 will be described.

In one embodiment, the control unit 120 may control the operation mode of the measuring unit 110 according to whether the vehicle is stopped.

First, the control unit 120 may judge whether the vehicle is stopped, when the operation mode of the measuring unit 110 is a wake-up mode and the operation state of the charging and discharging relay 20 is a turn-off state.

Hereinafter, for convenience of description, it is assumed that the control unit 120 can receive the speed information of the vehicle and/or the rotation information of the wheel from the vehicle control device 3.

For example, the control unit 120 may receive the speed information of the vehicle from the vehicle control device 3. If the speed of the vehicle is equal to or lower than a preset criterion speed, the control unit 120 may judge that the vehicle is stopped. For example, the preset criterion speed may be 1 km/h. Preferably, the preset criterion speed may be 0.5 km/h. More preferably, the preset criterion speed may be 0.1 km/h.

As another example, the control unit 120 may receive the rotation information of the wheel from the vehicle control device 3. If the rotation information of the wheel is equal to or lower than a preset criterion rotation value, the control unit 120 may judge that the vehicle is stopped.

As another example, the control unit 120 may judge whether the vehicle is stopped in consideration of both the speed information of the vehicle and the rotation information of the wheel received from the vehicle control device 3. That is, when the speed of the vehicle is equal to or lower than the preset criterion speed and the rotation information of the wheel is equal to or lower than the preset criterion rotation value, the control unit 120 may judge that the vehicle is stopped.

Next, the control unit 120 may be configured to change the operation mode of the measuring unit 110 to the eco-mode when it is judged that the vehicle is stopped.

For example, the control unit 120 may change the operation mode of the measuring unit 110 to the eco-mode when the connection between the battery pack 1 and the motor of the vehicle is released since the operation state of the charging and discharging relay 20 is a turn-off state and it is judged that the vehicle is stopped.

Through this, the frequency at which the measuring unit 110 measures the voltage of the main battery 10 may be reduced, so the energy of the main battery 10 consumed by the measuring unit 110 may be reduced.

That is, the overdischarge preventing apparatus 100 may prevent the main battery 10 from being overdischarged by changing the measurement mode of the measuring unit 110 to the eco-mode when the vehicle is not in a running state (e.g., when the operation state of the charging and discharging relay 20 is a turn-off state and the vehicle is a stopped state).

In another embodiment, the control unit 120 may be configured to change the operation mode of the measuring unit 110 to the eco-mode, when the present voltage of the main battery 10 is equal to or lower than a preset threshold voltage.

Here, the threshold voltage may be preset to be equal to or greater than a preset discharge termination voltage for the main battery 10. In other words, the threshold voltage may be a voltage value obtained by adding a predetermined margin to the preset discharge termination voltage for the main battery 10. For example, the discharge termination voltage of the main battery 10 may be preset to 2.5 V, and the threshold voltage may be preset to 2.8 V. That is, the threshold voltage may be a criterion voltage preset such that the operation mode of the measuring unit 110 is changed to the eco-mode in order to prevent the main battery 10 from being overdischarged even though the voltage of the main battery 10 does not reach the discharge termination voltage.

Specifically, the control unit 120 may be configured to change the operation mode of the measuring unit 110 to the eco-mode, when the operation mode of the measuring unit 110 is a wake-up mode, the operation state of the charging and discharging relay 20 is a turn-off state, and the present voltage of the main battery 10 is equal to or lower than the preset threshold voltage.

For example, the measuring unit 110 may continuously measure the voltage of the main battery 10 even if the operation state of the charging and discharging relay 20 is a turn-off state. Since the main battery 10 may be discharged naturally even if it is not electrically connected to the motor, the measuring unit 110 may continuously measure the state of the main battery 10 even if the charging and discharging relay 20 is in the turn-off state. However, since the measuring unit 110 receives the operating power from the main battery 10, as the measuring unit 110 operates, the main battery 10 may be overdischarged. Therefore, the overdischarge preventing apparatus 100 may prevent the main battery 10 from being overdischarged by changing the measurement mode of the measuring unit 110 to the eco-mode, even when the operation state of the charging and discharging relay 20 is the turn-off state and the voltage of the main battery 10 is equal to or lower than the threshold voltage.

In another embodiment, the control unit 120 may change the operation mode of the measuring unit 110 to the eco-mode, when the voltage of the main battery 10 decreases at a criterion ratio or more during a plurality of cycles.

Specifically, the control unit 120 may calculate a voltage decrease rate between the previous cycle voltage and the present cycle voltage of the main battery 10 measured by the measuring unit 110. For example, the voltage decrease rate may be calculated as a ratio of the present cycle voltage to the previous cycle voltage or a voltage deviation between the previous cycle voltage and the present cycle voltage.

More specifically, when the voltage decrease rate calculated in each of the plurality of successive cycles including the present cycle is equal to or greater than the preset criterion ratio, the control unit 120 may change the operation mode of the measuring unit 110 from the wake-up mode to the eco-mode.

For example, it is assumed that the present cycle is the N^{th} cycle and the previous cycle is the N-1^{th} cycle. In addition, it is assumed that the control unit 120 controls the operation mode of the measuring unit 110 in consideration of the voltage decrease rates of three cycles including the present cycle (N^{th} cycle). When the voltage decrease rate in each of the N^{th} cycle, the N-1^{th} cycle and the N-2^{th} cycle is equal to or greater than the criterion ratio, the control unit 120 may change the operation mode of the measuring unit 110 to the eco-mode.

That is, the overdischarge preventing apparatus 100 may prevent the main battery 10 from being discharged by changing the operation mode of the measuring unit 110 to the eco-mode, when the voltage of the main battery 10 continuously decreases at the criterion ratio or more during a plurality of cycles, even if the present voltage of the main battery 10 is equal to or greater than the threshold voltage.

According to the above non-limiting embodiment, the overdischarge preventing apparatus 100 may reduce the frequency at which the measuring unit 110 measures the voltage of the main battery 10 by appropriately controlling the operation mode of the measuring unit 110. Accordingly, since the energy of the main battery 10 consumed by the measuring unit 110 may be reduced, it is possible to effectively prevent the main battery 10 from being discharged.

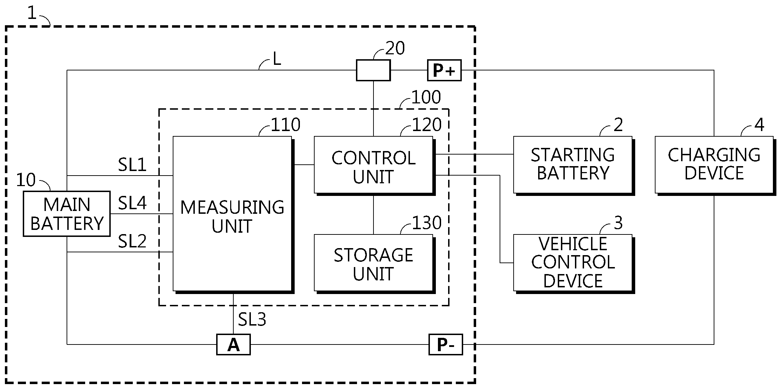

FIG. 3 is a diagram schematically showing another exemplary configuration of a vehicle according to another embodiment of the present disclosure.

Referring to FIG. 3, the battery pack 1 may be connected to the starting battery 2 and the vehicle control device 3. In addition, the battery pack 1 may be connected to the charging device 4. Specifically, the positive electrode terminal P+ of the battery pack 1 and the negative electrode terminal P- of the battery pack 1 may be connected to the charging device 4.

After the operation mode of the measuring unit 110 is changed to the eco-mode, the control unit 120 may be configured to control the charging and discharging relay 20 or the operation mode of the measuring unit 110 according to whether the charging device 4 is connected to the battery pack 1 within a preset time.

Specifically, when the operation mode of the measuring unit 110 is changed to the eco-mode, the control unit 120 may calculate whether the battery pack 1 and the charging device 4 are connected and the time required for connection. Here, the time required for connection may be a time taken from the time point when the operation mode of the measuring unit 110 is changed to the eco-mode to the time point when the battery pack 1 and the charging device 4 are connected.

For example, it is assumed that the operation mode of the measuring unit 110 is changed to the eco-mode at the time point t0, and the charging device 4 is connected to the battery pack 1 at the time point t1. The control unit 120 may calculate that the charging device 4 is connected at the time tl and the time required for connection for the charging device 4 is "t1-t0".

In addition, the control unit 120 may be configured to charge the main battery 10 through the charging device 4 by controlling the operation state of the charging and discharging relay 20 to the turn-on state, when the charging device 4 is connected to the battery pack 1 within the preset time.

In this case, since the main battery 10 is charged by the charging device 4, it is possible to prevent the main battery 10 from being overdischarged. Therefore, the control unit 120 may charge the main battery 10 by controlling the operation state of the charging and discharging relay 20 to the turn-on state, when the charging device 4 is connected to the battery pack 1 within the preset time.

In addition, when the voltage of the main battery 10 exceeds the preset criterion voltage, the control unit 120 may be configured to change the operation mode of the measuring unit 110 from the eco-mode to the wake-up mode. That is, the control unit 120 may change the operation mode of the measuring unit 110 from the eco-mode to the wake-up mode so that the voltage of the main battery 10 is measured in a shorter cycle, when the main battery 10 is charged by the charging device 4 and thus the voltage of the main battery 10 exceeds the criterion voltage.

Conversely, the control unit 120 may be configured to change the operation mode of the measuring unit 110 to the shutdown mode, when the charging device 4 is not connected to the battery pack 1 within the preset time.

That is, when the charging device 4 is not connected to the battery pack 1 within the preset time, the control unit 120 may change the operation mode of the measuring unit 110 from the eco-mode to the shutdown mode in order to prevent the energy of the main battery 10 from being consumed by the measuring unit 110 operated in the eco-mode. In this case, since it is impossible to measure the voltage of the main battery 10 by the measuring unit 110, the control unit 120 may change the operation mode of the measuring unit 110 periodically or aperiodically to the wake-up mode or the eco-mode to measure the voltage of the main battery 10.

The overdischarge preventing apparatus 100 according to an embodiment of the present disclosure may control the operation mode of the measuring unit 110 in order to save the energy of the main battery 10 consumed in the process of measuring the state (e.g., at least one of voltage, current and temperature) of the main battery 10. In addition, the overdischarge preventing apparatus 100 may further control the operation mode of the measuring unit 110 in order to further save the energy of the main battery 10 based on whether the charging device 4 is connected. Therefore, since the energy of the main battery 10 consumed by the measuring unit 110 may be saved to the maximum, it is possible to effectively prevent the main battery 10 from being overdischarged.

The overdischarge preventing apparatus 100 according to the present disclosure may be applied to a BMS (Battery Management System). That is, the BMS according to the present disclosure may include the above-described overdischarge preventing apparatus 100. In this configuration, at least some of the components of the overdischarge preventing apparatus 100 may be implemented by supplementing or adding functions of the configuration included in a conventional BMS. For example, the measuring unit, the control unit and the storage unit of the overdischarge preventing apparatus 100 may be implemented as components of the BMS.

In addition, the overdischarge preventing apparatus 100 according to the present disclosure may be provided to a battery pack. For example, the battery pack according to the present disclosure may include the overdischarge preventing apparatus 100 as described above and at least one battery cell. In addition, the battery pack may further include electrical equipment (a relay, a fuse, etc.), a case, and the like.

The positive electrode terminal of the main battery 10 may be connected to the positive electrode terminal P+ of the battery pack 1, and the negative electrode terminal of the main battery 10 may be connected to the negative electrode terminal P- of the battery pack 1.

The measuring unit 110 may be connected to the first sensing line SL1, the second sensing line SL2, the third sensing line SL3 and the fourth sensing line SL4. Specifically, the measuring unit 110 may be connected to the positive electrode terminal of the main battery 10 through the first sensing line SL1, and may be connected to the negative electrode terminal of the main battery 10 through the second sensing line SL2. The measuring unit 110 may measure the voltage of the main battery 10 based on the voltage measured at each of the first sensing line SL1 and the second sensing line SL2.

In addition, the measuring unit 110 may be connected to the current measuring unit A through the third sensing line SL3. For example, the current measuring unit A may be an ammeter or a shunt resistor capable of measuring the charging current and the discharging current of the main battery 10. The measuring unit 110 may calculate the charge amount by measuring the charging current of the main battery 10 through the third sensing line SL3. Also, the measuring unit 110 may calculate the discharge amount by measuring the discharging current of the main battery 10 through the third sensing line SL3.

Also, the measuring unit 110 may measure the temperature of the main battery 10 through the fourth sensing line SL4. For example, one end of the fourth sensing line SL4 may be connected to a temperature measuring element, and the other end may be connected to the measuring unit 110. For example, the temperature measuring element may be a Negative Temperature Coefficient of Resistance (NTC) device or a Positive Temperature Coefficient of Resistance (PTC) device. Therefore, the measuring unit 110 may measure the temperature of the main battery 10 through the fourth sensing line SL4.

One end of charging device 4 may be connected to the positive electrode terminal P+ of the battery pack 1, and the other end may be connected to the negative electrode terminal P- of the battery pack 1. Accordingly, the positive electrode terminal of the main battery 10, the positive electrode terminal P+ of the battery pack 1, the charging device 4, the negative electrode terminal P- of the battery pack 1, and the negative electrode terminal of the main battery 10 may be electrically connected.

Meanwhile, when a wake-up signal is received from the starting battery 2 different from the main battery 10, the control unit 120 may be configured to change the operation mode from the sleep mode to the wake-up mode.

That is, the control unit 120 may operate in the sleep mode before receiving a wake-up signal from the starting battery 2. Thereafter, when a wake-up signal is received from the starting battery 2, the control unit 120 may change the operation mode from the sleep mode to the wake-up mode.

In addition, the control unit 120 may be configured to change the operation mode of the measuring unit 110 from the shutdown mode to the wake-up mode.

That is, the control unit 120 may change the operation mode of the measuring unit 110 from the shutdown mode to the wake-up mode in order to measure the state of the main battery 10, when its operation mode is changed from the sleep mode to the wake-up mode.

In addition, when the operation mode is the wake-up mode or the eco-mode, the measuring unit 110 may be configured to receive the operating power from the main battery 10 and measure the voltage of the main battery 10.

As described above, the measuring unit 110 may measure the state of at least one of voltage, current, and temperature of the main battery 10. In addition, the operation mode of the measuring unit 110 may be controlled by the control unit 120 so that the main battery 10 is not overdischarged.

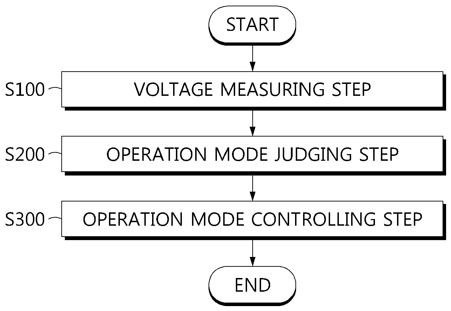

FIG. 4 is a diagram schematically showing an overdischarge preventing method according to another embodiment of the present disclosure.

Preferably, the overdischarge preventing method is a method of preventing the battery pack 1 provided in a vehicle from being overdischarged, and each step of the overdischarge preventing method may be performed by the overdischarge preventing apparatus. Hereinafter, for convenience of description, the content overlapping with the previously described content will be omitted or briefly described.

Referring to FIG. 4, the overdischarge preventing method may include a voltage measuring step (S100), an operation state judging step (S200), and an operation mode controlling step (S300).

The voltage measuring step (S100) is a step of measuring the voltage of the main battery 10 provided in the battery pack 1, and may be performed by the measuring unit 110.

Preferably, the measuring unit 110 may measure the voltage of the main battery 10 in different measurement cycles according to the operation mode, and the operation mode of the measuring unit 110 may be controlled by the control unit 120.

The operation state judging step (S200) is a step of judging the operation state of the charging and discharging relay 20 connected to the main battery 10, and may be performed by the control unit 120.

For example, the control unit 120 may control the operation state of the charging and discharging relay 20. Therefore, the control unit 120 may judge the operation state of the charging and discharging relay 20 as a turn-on state or a turn-off state based on the control information for the charging and discharging relay 20.

The operation mode controlling step (S300) is a step of controlling the operation mode of the measuring unit 110 based on at least one of the operation state of the charging and discharging relay 20, whether the vehicle is stopped, and the voltage of the main battery 10, and may be performed by the control unit 120.

Specifically, the operation mode controlling step (S300) may be performed by the control unit 120 when the operation state of the charging and discharging relay 20 is a turn-off state.

For example, the control unit 120 may change the operation mode of the measuring unit 110 to the eco-mode, when the operation state of the charging and discharging relay 20 is the turn-off state and the vehicle is the stopped state.

As another example, the control unit 120 may change the operation mode of the measuring unit 110 to the eco-mode, when the operation state of the charging and discharging relay 20 is the turn-off state and the voltage of the main battery 10 decreases at the criterion ratio or more in a plurality of continuous cycles.

As another example, the control unit 120 may change the operation mode of the measuring unit 110 to the eco-mode, when the operation state of the charging and discharging relay 20 is the turn-off state and the voltage of the main battery 10 is equal to or lower than the threshold voltage.

As another example, when the operation state of the charging and discharging relay 20 is the turn-off state, the control unit 120 may control the operation mode of the measuring unit 110 in consideration of at least two of whether the vehicle is stopped, the voltage of the main battery 10 and the voltage decrease rate of the main battery 10.

In addition, after the operation mode of the measuring unit 110 is changed to the eco-mode, the control unit 120 may change the operation mode of the measuring unit 110 to the shutdown mode based on whether the battery pack 1 and the charging device 3 are connected.

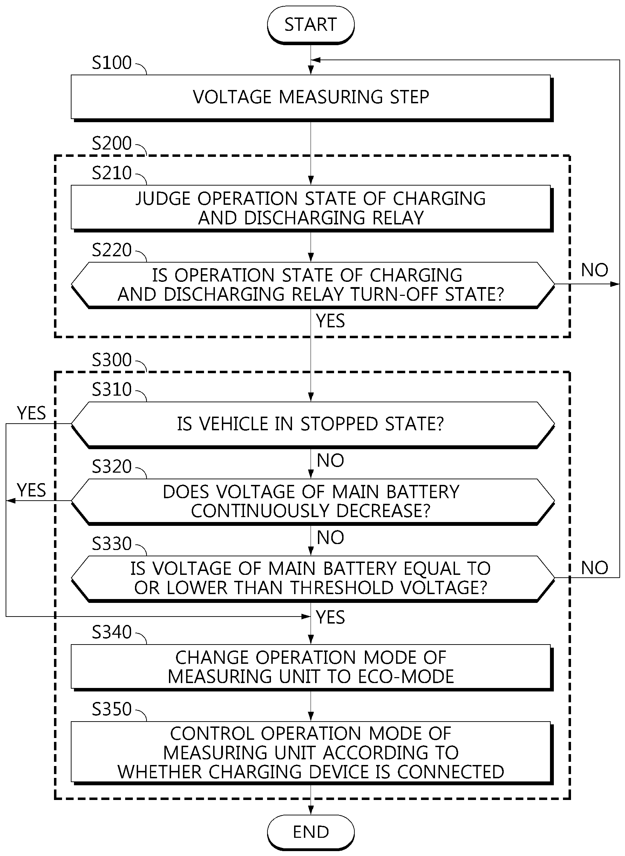

FIG. 5 is a diagram more specifically showing the overdischarge preventing method according to another embodiment of the present disclosure.

Specifically, the embodiment of FIG. 5 is an embodiment in which the control unit 120 controls the operation mode of the measuring unit 110 in consideration of all of whether the vehicle is stopped, the voltage of the main battery 10, and the voltage decrease rate of the main battery 10.

Hereinafter, an embodiment in which the control unit 120 controls the operation mode of the measuring unit 110 in consideration of the steps S310, S320 and S330 based on FIG. 5 will be described, but it should be noted that the control unit 120 may control the operation mode of the measuring unit 110 by selectively applying at least one of the steps S310, S320 and S330. For example, in the case of an embodiment in which the control unit 120 controls the operation mode of the measuring unit 110 based on whether the vehicle is stopped and the voltage of the main battery 10, the step S320 may be omitted in the embodiment of FIG. 5, and if the judgment result of the step S310 is "NO", the step S330 may be performed.

The operation state judging step (S200) may include the steps S210 and S220.

In the step S210, the control unit 120 may judge the operation state of the charging and discharging relay 20.

After that, if the operation state of the charging and discharging relay 20 judged by the control unit 120 in the step S220 is a turn-off state, the operation mode controlling step (S300) may be performed, and if the operation state of the charging and discharging relay 20 is a turn-on state, the voltage measuring step (S100) may be performed. That is, the operation mode controlling step (S300) may be performed only when the operation state of the charging and discharging relay 20 is a turn-off state.

In the step S310, it may be judged whether the vehicle is in a stopped state. Specifically, the control unit 120 may judge whether the vehicle is stopped based on at least one information received from the vehicle control device 3.

If it is judged that the vehicle is in the stopped state in step S310, the control unit 120 may perform the step S340. Otherwise, the control unit 120 may perform the step S320.

In the step S320, it may be judged whether the voltage of the main battery 10 continuously decreases. Specifically, the control unit 120 may judge whether the voltage of the main battery 10 decreases at a criterion ratio or more in each of a plurality of continuous cycles including the present cycle.

For example, in each cycle, the control unit 120 may calculate a voltage decrease rate of the main battery 10 based on a difference between the voltage of the main battery 10 in the present cycle and the voltage of the main battery 10 in the previous cycle. The control unit 120 may perform the step S340 when the voltage of the main battery 10 decreases at the criterion ratio or more in a plurality of continuous cycles. Otherwise, the control unit 120 may perform the step S330.

In the step S330, it may be judged whether the voltage of the main battery 10 is lower than or equal to a threshold voltage. Specifically, if the voltage of the main battery 10 measured in the present cycle is lower than or equal to the threshold voltage, the step S340 may be performed. Otherwise, the voltage measuring step (S100) may be performed.

In the step S340, the operation mode of the measuring unit 110 may be changed to the eco-mode. Specifically, the operation mode of the measuring unit 110 may be changed from the wake-up mode to the eco-mode.

That is, in the case where the operation state of the charging and discharging relay 20 is the turn-off state, the control unit 120 may change the operation mode of the measuring unit 110 from the wake-up mode to the eco-mode, if the vehicle is in a stopped state, or if the voltage of the main battery 10 continuously decreases during a plurality of cycles, or if the voltage of the present cycle of the main battery 10 is equal to or lower than the threshold voltage. By changing the operation mode of the measuring unit 110 to the eco-mode, the energy consumption of the main battery 10 by the measuring unit 110 may be reduced. Accordingly, it is possible to prevent the main battery 10 from being overdischarged by operating the measuring unit 110.

In the step S350, the control unit 120 may control the operation mode of the measuring unit 110 according to whether the charging device 4 is connected to the battery pack 1 within a preset time from the time point when the operation mode of the measuring unit 110 is changed to the eco-mode.

For example, when the charging device 4 is connected to the battery pack 1 within the preset time from the time point when the operation mode of the measuring unit 110 is changed to the eco-mode by the step S340, the control unit 120 may change the operation mode of the measuring unit 110 from the eco-mode to the wake-up mode again.

Conversely, if the charging device 4 is not connected to the battery pack 1 within the preset time from the time point when the operation mode of the measuring unit 110 is changed to the eco-mode by the step S340, the control unit 120 may change the operation mode of the measuring unit 110 from the eco-mode to the shutdown mode.

According to the overdischarge preventing method including the voltage measuring step (S100), the operation state judging step (S200) and the operation mode controlling step (S300), the main battery 10 may be effectively prevented from being overcharged by properly controlling the operation mode of the measuring unit 110.

The embodiments of the present disclosure described above are not necessarily implemented by an apparatus and method but may also be implemented through a program for realizing functions corresponding to the configuration of the present disclosure or a recording medium on which the program is recorded. Such implementation may be easily performed by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Reference Signs)

1: battery pack
2: starting battery
3: vehicle control device
4: charging device
10: main battery
20: charging and discharging relay
100: overdischarge preventing apparatus
110: measuring unit
120: control unit
130: storage unit

## Claims

1. An overdischarge preventing apparatus for preventing a battery pack provided in a vehicle from being overdischarged, comprising:
a measuring unit configured to measure a voltage of a main battery provided in the battery pack according to an operation mode; and
a control unit configured to judge an operation state of a charging and discharging relay connected to the main battery, and control the operation mode of the measuring unit based on at least one of the judged operation state of the charging and discharging relay, whether the vehicle is stopped, and the voltage of the main battery measured by the measuring unit.

2. The overdischarge preventing apparatus according to claim 1,
wherein the measuring unit is configured to operate in any one operation mode among a wake-up mode in which the voltage of the main battery is measured in a first measurement cycle, an eco-mode in which the voltage of the main battery is measured in a second measurement cycle longer than the first measurement cycle, and a shutdown mode in which the voltage of the main battery is not measured.

3. The overdischarge preventing apparatus according to claim 2,
wherein the control unit is configured to control the operation mode of the measuring unit based on at least one of whether the vehicle is stopped and the voltage of the main battery, when the operation mode of the measuring unit is the wake-up mode and the operation state of the charging and discharging relay is a turn-off state.

4. The overdischarge preventing apparatus according to claim 3,
wherein the control unit is configured to judge whether the vehicle is stopped, and change the operation mode of the measuring unit to the eco-mode when it is judged that the vehicle is stopped.

5. The overdischarge preventing apparatus according to claim 4,
wherein the control unit is configured to judge whether the vehicle is stopped, based on at least one of speed information of the vehicle and rotation information of a wheel, which are received from the outside.

6. The overdischarge preventing apparatus according to claim 3,
wherein the control unit is configured to change the operation mode of the measuring unit to the eco-mode, when a present voltage of the main battery is equal to or lower than a preset threshold voltage.

7. The overdischarge preventing apparatus according to claim 3,
wherein the control unit is configured to change the operation mode of the measuring unit to the eco-mode, when the voltage of the main battery decreases at a criterion ratio or more during a plurality of cycles.

8. The overdischarge preventing apparatus according to claim 2,
wherein the control unit is configured to control the charging and discharging relay or the operation mode of the measuring unit according to whether a charging device is connected to the battery pack within a preset time, after the operation mode of the measuring unit is changed to the eco-mode.

9. The overdischarge preventing apparatus according to claim 8,
wherein the control unit is configured to charge the main battery through the charging device by controlling the operation state of the charging and discharging relay to a turn-on state, when the charging device is connected to the battery pack within the preset time.

10. The overdischarge preventing apparatus according to claim 9,
wherein the control unit is configured to change the operation mode of the measuring unit from the eco-mode to the wake-up mode, when the voltage of the main battery exceeds a preset criterion voltage.

11. The overdischarge preventing apparatus according to claim 8,
wherein the control unit is configured to change the operation mode of the measuring unit to the shutdown mode, when the charging device is not connected to the battery pack within the preset time.

12. The overdischarge preventing apparatus according to claim 2,
wherein when the control unit receives a wake-up signal from a starting battery different from the main battery, the control unit is configured to change an operation mode from a sleep mode to a wake-up mode and change the operation mode of the measuring unit from the shutdown mode to the wake-up mode, and
wherein when the operation mode of the measuring unit is the wake-up mode or the eco-mode, the measuring unit is configured to receive an operating power from the main battery and measure the voltage of the main battery.

13. A battery pack, comprising the overdischarge preventing apparatus according to any one of claims 1 to 12.

14. A vehicle, comprising the overdischarge preventing apparatus according to any one of claims 1 to 12.

15. An overdischarge preventing method for preventing a battery pack provided in a vehicle from being overdischarged, comprising:
a voltage measuring step of, by a measuring unit, measuring a voltage of a main battery provided in the battery pack;
an operation state judging step of, by a control unit, judging an operation state of a charging and discharging relay connected to the main battery; and
an operation mode controlling step of, by the control unit, controlling an operation mode of the measuring unit based on at least one of the operation state of the charging and discharging relay, whether the vehicle is stopped, and the voltage of the main battery.
